Europäisches Patentamt

European Patent Office

Office européen des brevets

(11) Publication number: **0 411 145 A1**

## EUROPEAN PATENT APPLICATION
### published in accordance with Art. 158(3) EPC

(21) Application number: 90902703.9

(22) Date of filing: 01.02.90

(86) International application number:
PCT/JP90/00126

(87) International publication number:
WO 90/09047 (09.08.90 90/19)

(51) Int. Cl.5: **H01S 3/18**, H01L 27/14

(30) Priority: 02.02.89 JP 22674/89

(43) Date of publication of application:
06.02.91 Bulletin 91/06

(84) Designated Contracting States:
**DE FR GB**

(71) Applicant: FUJITSU LIMITED
1015, Kamikodanaka Nakahara-ku
Kawasaki-shi Kanagawa 211(JP)

(72) Inventor: SODA, Haruhisa
2-25-3-201, Tobio Atsugi-shi
Kanagawa 243-02(JP)
Inventor: ISHIKAWA, Hiroshi
5-32-14-105, Sagamigaoka Zama-shi
Kanagawa 228(JP)

(74) Representative: Sunderland, James Harry et al
HASELTINE LAKE & CO Hazlitt House 28
Southampton Buildings Chancery Laneane
London WC2A 1AT(GB)

(54) INTEGRATED OPTICAL SEMICONDUCTOR DEVICE AND METHOD OF PRODUCING THE SAME.

(57) An integrated optical semiconductor device having improved optical coupling efficiency between optical semiconductor devices. An optical waveguide layer (3) is provided on a semiconductor substrate (1). On the waveguide layer, a first active layer (103) and a second active layer (104) having nearly the same thickness are provided, and they are directly coupled together along the end surface (107) to constitute a first optical semiconductor device (105) and a second optical semiconductor device (106). In the step of manufacture, an etching stop layer is interposed in advance between the optical waveguide layer (3) and the first active layer (103). Owing to this constitution, the two active layers are formed maintaining nearly an equal height without permitting the optical waveguide layer (3) to be etched. Therefore, there is obtained an integrated optical semiconductor device having good optical coupling efficiency.

Embodiment 1

Fig. 5

# INTEGRATED OPTICAL SEMICONDUCTOR DEVICE AND METHOD OF MANUFACTURING THE SAME

FIELD OF THE INVENTION

The present invention relates to an integrated optical semiconductor device and a method of manufacturing the same and more specifically to an integrated optical semiconductor device and a method of manufacturing the same which has integrated a plurality of optical semiconductor devices by joining the end faces of the active layers of such optical semiconductor devices on an optical waveguide layer.

BACKGROUND OF THE INVENTION

Development of an optical semiconductor devices such as DFB laser, photodetecotr and photoamplifier has been continued for improvement in optical communication or optical data processing.

However, the performance which may be realized by the discrete conventional optical semiconductor device is actually reaching the limit and therefore it is necessary to realize the more improved performance through integration of several optical semiconductor devices on the same substrate.

For instance, in an example of DFB laser which is used as the light source of optical communication system, in case a discrete DFB laser is used and such laser beam is modulated in direct with an applied current, a phenomenon, so-called the charping phenomenon in which a number of carriers in the DFB laser changes and oscillation wavelength changes with time is generated. This charping phenomenon is a factor for deteriorating optical transmission characteristics when an optical fiber having chromatic dispersion is used. Therefore such optical fiber cannot be used in the optical transmission exceeding 5 Gb/s. But, this charping phenomenon can be suppressed to an extremely small value by employing the structure to integrate the DFB laser and optical modulator on the same substrate in order to modulate the laser beam emitted from the DFB laser with an optical modulator in place of direct modulation of the DFB laser beam, namely employing an external modulation system.

However, efficiency of optical coupling between the integrated semiconductor devices gives a large influence on improvement in characteristics of optical semiconductor devices integrated as explained above.

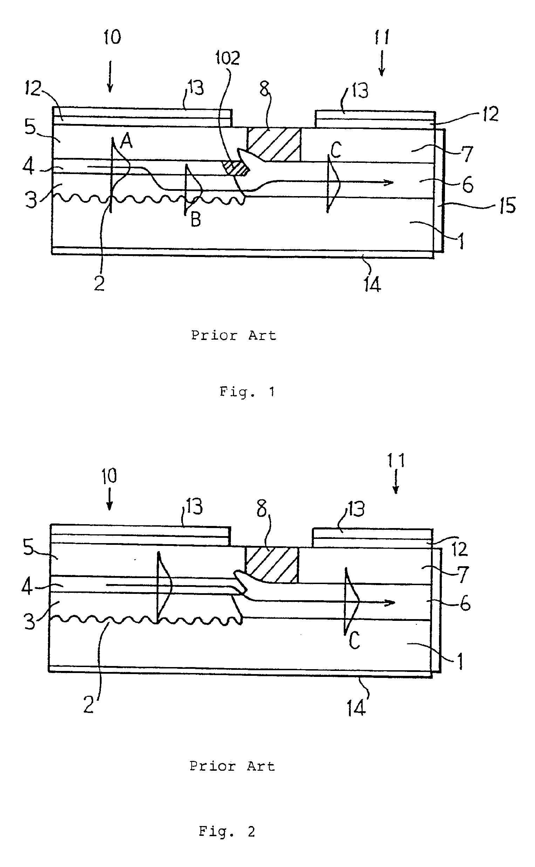

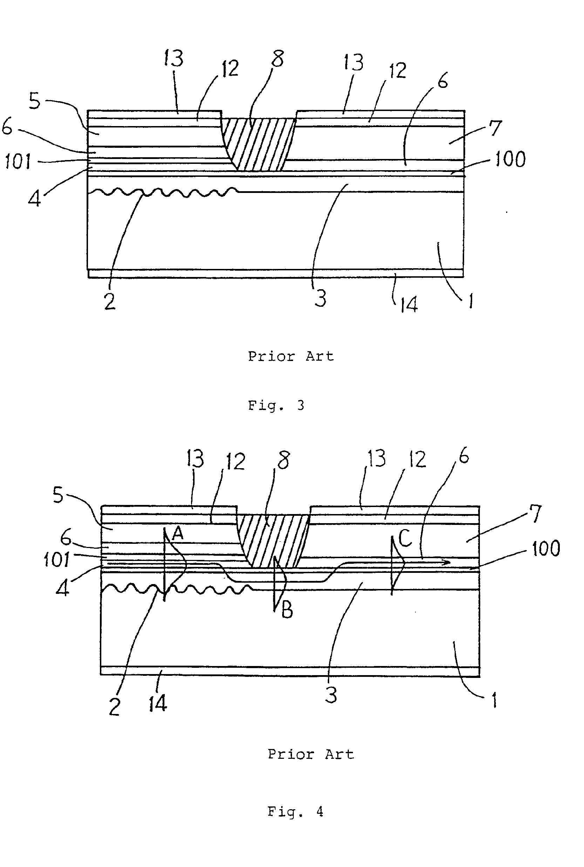

Fig. 1 and Fig. 3 indicate a conventional integrated optical semiconductor device packing the DFB laser and optical modulator on the same substrate.

An integrated optical semiconductor device shown in Fig. 1 comprises a DFB laser 10 consisting of a diffraction grating 2, a waveguide layer 3, an active l ayer 4 and a clad layer 5 formed in the left side on the n-InP substrate 1 and an optical modulator 11 consisting of an absorption layer 6 and p-InP layer 7 formed in the right side of the n-InP substrate 1 and also provides a high resistance layer 8 between the DFB laser 10 and optical modulator 11.

Moreover, a cap layer 12 and an upper electrode 13 are provided on the upper surface, while a lower electrode 14 on the lower surface and an anti-reflection film 15 is provided to the end face in the side of optical modulator.

An integrated optical semiconductor device shown in Fig. 3 has been disclosed in the Japanese Patent Laid-open No. 64-28984, in which a diffraction grating 2 is provided in the left side of n-InP substrate 1 and an optical waveguide layer 3 and a first buffer layer 100 are provided on the entire part of InP substrate 1, thereafter an active layer 4, a second buffer layer 101 and a clad layer 5 forming the DFB laser 10 are provided on the diffraction grating 2, while an optical absorbing layer 6 (extending up to the region of DFB laser 10) and P-InP layer 7 forming an optical modulator 11 are provided in the right side of the n-Inp substrate 1. The DFB laser 10 and optical modulator 11 are separated by forming a groove between them and burying a high resistance layer 8 therein. when the groove is to be formed, the first buffer layer 100 works as an etching stopper and therefore etching is not conducted up to the optical waveguide layer 3 at the lower side.

Moreover, a cap layer 12 and an upper electrode 13 are provided at the upper surface, while a lower electrode 14 at the lower surface.

As explained above, various methods have been discussed to form optical semiconductor devices on the same substrate but these methods conceive the problems that optical coupling between both optical semiconductor devices canot be realized efficiently.

First, since the active layer 4 and optical waveguide layer 3 in contact therewith are formed by compound semiconductor of the same group in the integrated optical semiconductor device shown in Fig. 1, the optical waveguide layer 3 is also etched simultaneously with the etching of the active layer 4.

In this case, since an etching rate of active layer 4 is high, the actie layer 3 is also side-etched up to 2 3 um and accordingly when the optical absorbing layer 6 grows later, the crystal does not grow in the side-etched region and a hole 102 is formed.

When a hole 102 is formed, optical coupling between the DFB laser 10 and optical modulator 11 is made through a route of of active layer 4 - optical waveguide layer 3 - optical absorbing layer 6. However since the power of light to be propagated becomes maximum at the center area of each layer, mismatching occurs in the coupling of lights in the active layer 4, optical waveguide layer 3 and optical absorbing layer 6, as shown in A, B, C, due to the region where the light propagates most intensively, namely due to the structure of Fig. 1 in which the height of the center area is different and efficient optical coupling cannot be realized.

In addition, even when a hle 102 is not formed, as shown in Fig. 2, the center area A of active layer 4 and the center area B of the optical absorbing layer 6 are different in height. As a result, mismatching is also generated.

Meanwhile, in the structure shown in Fig. 3, optical coupling between the DFB laser 10 and optical modulator 11 is carried out through a route of active layer 4 - optical waveguide layer 3 - optical absorbing layer 6. Even in this case, since the centers of respective layers are different like A, B, C between the active layer 4 and optical waveguide layer 3 or between the optical waveguide layer 3 and optical absorbing layer 6, mismatching is also generated and efficient optical coupling cannot be realized.

In some cases, such mismatching is generated not only between the DFB laser and optical modulator but also between other integrated optical semiconductor devices.

## OBJECT AND DISCLOSURE OF THE INVENTION

It is a first object of the present invention to provide an integrated optical semiconductor device which efficiently realizes optical coupling between active layers of optical semiconductor devices in case of forming integrated optical semiconductor device stacking optical waveguide layer and active layer and another optical semiconductor deviceon the same substrate.

It is a second object of the present invention to provide a method for realizing efficient optical coupling between the active layers of optical semiconductor devices in case of forming integrated optical semiconductor device stacking optical waveguide layer and active layer and another optical semiconductor device on the same substrate.

In order to achieve the first object, the present invention provides an integrated optical semiconductor device comprising a semiconductor substrate providing an optical waveguide layer as the surface layer, a first optical semiconductor device which comprises a first active layer provided partially on the optical waveguide layer to operate through optical coupling between the optical waveguide layer and first active layer, and a second optical semiconductor device having a second active layer which is provided partially on the optical waveguide layer in contact with the end face of the first active layer at the end face thereof and has the bottom surface provided in the same plane as the first active layer.

Moreover, in order to achieve the second object, the present inevention provides a method of manufacturing an integrated optical semiconductor device comprising steps of forming an optical waveguide layer on a semiconductor substrate, forming a first active layer, on the etching stop layer, consisting of a substance different from that of such etching stop layer, exposing the etching stop layer by selectively etching the first active layer and forming a second active layer in contact with the surface exposed by the selective etching of the first active layer.

## BRIEF DESCRIPTION OF THE DRAWINGS

Fig. 1 Fig. 5 are diagrams for explaining the prior arts of the present invention.

Fig. 5 and Fig. 6 are diagrams for explaining embodiment of the basic structure of the present invention.

Fig. 7 and Fig. 8 are diagrams for explaining an embodiment in which the present invention is applied to integrated DFB laser and optimical modulator and Fig. 9 Fig. 13 are diagrams for explaining the manufacturing process.

Fig. 14 is a diagram for explaining an embodiment in which the present invention is applied to integrated optical amplifier and photo detector.

Fig. 15 is a diagram for explaining embodment in which the present invention is applied to integrated optical amplifier and optical filter.

## DETAILED DESCRIPTION OF THE PREFERRED EMBODIMENTS

### [Embodiment 1]

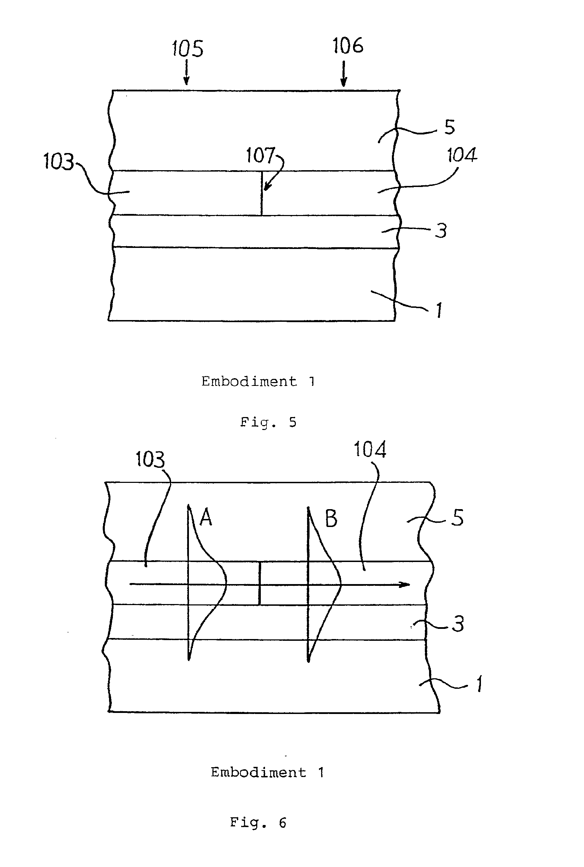

Fig. 5 is a diagram indicating an embodiment of the basic structure of the present invention.

In this embodiment, an optical waveguide layer 3 is provided on a semiconductor substrate 1, a first active layer 103 forming a first optical semiconductor device 105 is provided at the left upper side and a second active layer 104 forming a second optical semiconductor device 106 at the upper right side, respectively in the same thickness. The first and second active layers are coupled in direct at the end face 107.

A clad layer 5 is provided on the first and second active layers.

According to the structure of this embodiment, since an optical waveguide layer 3 is extending over both a first optical semiconductor device 105 and a second optical semiconductor device 106, the bottom surface of first active layer 103 is set in the same plane as the bottom surface of the second active layer 104. Accordingly, as shown in Fig. 6, the center positions A, B of the first and second active layers formed thereon become almost equal.

Therefore, the areas where the light is propagated most intensively are connected in direct, mismatching of optical coupling between both active layers is eliminated and efficient optical coupling can be realized.

[Embodiment 2]

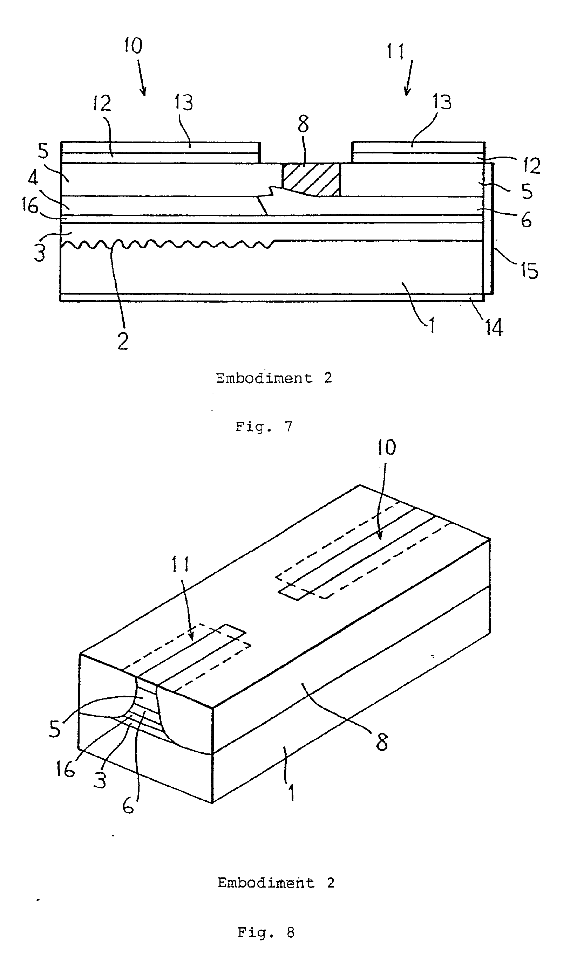

Fig. 7 and Fig. 8 are diargrams for explaining the second embodiment of the present invention.

As shown in Fig. 7, in this embodiment, the DFB laser 10 and the optical modulator 11 are integrated on the same substrate, a diffraction grating 2 is provided in the left side of the n-InP substrate 1 and the optical waveguide layer 3 and etching stop layer 16 are provided on the entire part of substrate.

In the left area of the substrate 1 forming the DFB laser 10, the active layer 4 to obtain the light (corresponding to the first active layer) and clad layer 5 are provided and in the right side area of the substrate 1 forming the optical modulator 11, the light absorbing layer 6 (active layer in the optical modulator: corresponding to the second active layer) and clad layer 5 are provided. Moreover, anti-reflection film 15 is formed at the end face thereof. A high resistance layer 8 is buried between the DFB lawer 10 and optical modulator 11 to separated them.

Moreover, the cap layer 12 and upper electrode 13 are separately provided on the DFB laser 10 and optical modulator 11 and a common lower electrode 14 is provided in the side of substrate 1.

Fig. 8 shows a structure where the cap layer 12, upper electrode 13 and lower electrode 14 are eliminated in the present embodiment. (A broken line indicates the position where the cap layer 12 and upper electrode are formed.)

As is obvious from Fig. 8, the high resistance layer 8 is buries not only between the DFB laser 10 and optical modulator 11 but also between both sides of each device.

In this embodiment, the DFB laser 10 is always caused to emit the light and the laser beam is modulated by a voltage to be applied to the optical modulator 11.

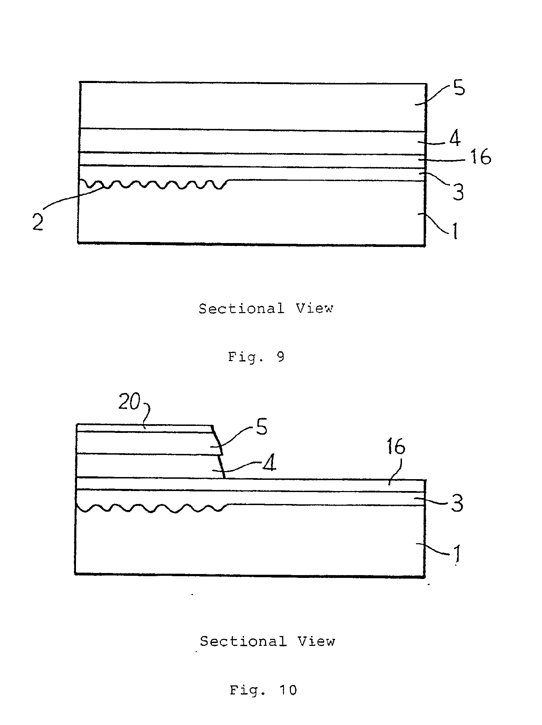

This embodiment will further be explained in more detail with reference to Figs. 9 to 13. Referring to Fig. 9:

For instance, the optical waveguide layer 3 consisting of GaInAsp (wavelength $\lambda_{PL}$ = 1.1 $\mu$m) is grown in the thickness of 0.15 $\mu$m, by the liquid growth method, the etching stop layer 16 consisting of InP is grown in the thickness of 0.01 $\mu$m, the active layer 4 consisting of GaInAsP (wavelength $\lambda_{PL}$ = 1.55 $\mu$m) is grown in the thickness of 0.15 um and the clad layer 5 consisting of p-InP is grown in the thickness of 0.5 $\mu$m sequentially on the n-InP substrate 1 providing the diffraction grtating 2 formed with a resist pattern through interference exposure using He-Cd laser. Referring to Fig. 10:

After a mask 20 which is formed by $SiO_2$, for example, and covers the left side area as the DFB laser in the legnth of about 300 $\mu$m is formed selectively in the thickness of about 2000Å, the clad layer 5 formed by InP is selectively etched with the etchant, for example, consisting of HC and thereafter the active layer 4 is selectively removed with the etchant consisting of $H_2SO_4$, $H_2O_2$, $H_2O$.

In this case, since the active layer 4 is formed by GaInAsP and the etching stop layer 16 is formed by InP, the etching stop layer 16 is substantially never etched due to difference of substances.

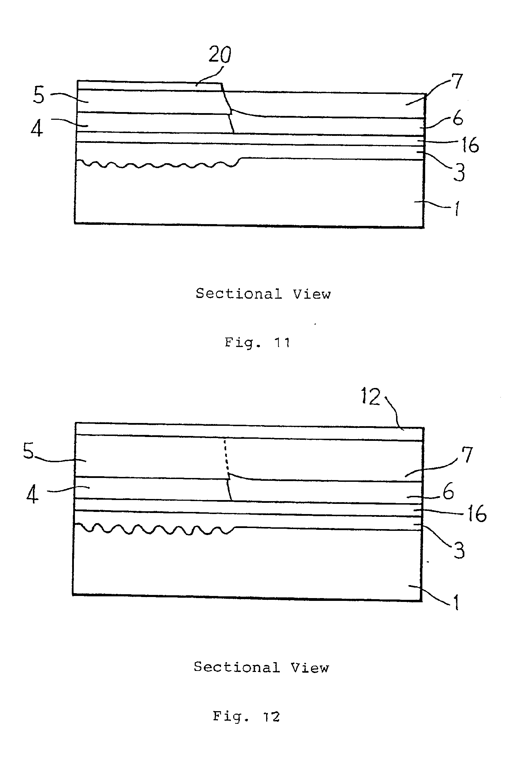

Moreover, since the active layer 4 is the layer as thin as about 15 $\mu$m, long etching time is not required and the side etching is little generated. Referring to Fig. 11:

Using the mask 20, the light absorbing layer 6 consisting of GaInAsP (wavelength $\lambda_{PL}$ = 1.4 $\mu$m) and the clad layer 7 of opticam modulator 11 consisting of p-InP are respectively formed selectively by the liquid growth method in the area from which the active layer 4 and clad layer 5 are removed by the etching. Referring to Fig. 8 and Fig. 12:

After the mask 20 is removed, the areas of DFB laser 10 and optical modulator 11 are etched to mesa type and a high resistance layer 8 consisting of the Fe-doped InP is grown therein.

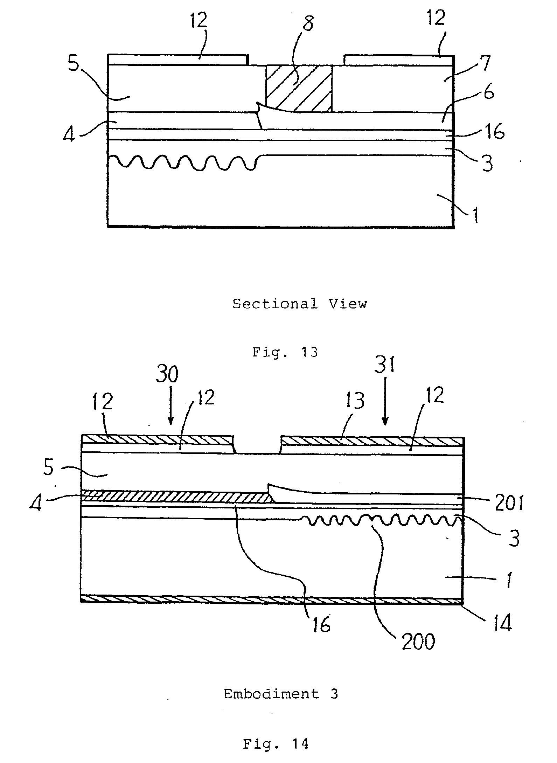

Thereafter, the cap layer 12 consisting of In-AsP (wavelength $\lambda_{PL}$ = 1.3 $\mu$m) is formed at the surface in the thickness of 2000Å. Referring to Fig. 13:

The cap layer 12 on the DFB laser 10 and optical modulator 11 is selectively etched and the optical semiconductor devices are separated mutually and thereafter a groove is formed on the clad layer 7 exposed by the etching.

In succession, the groove is filled with the high resistance layer 8 consisting of Fe-doped InP to separate the DFB laser 30 and the optical modulator 31. However, when the cap layer 12 of DFB laser 30 and the cap layer 12 of optical modulator 31 are separated by 10 $\mu$m or more, sufficient electrical separation may be possible without burying the groove with the high resistance layer 8.

Thereafter, the upper electrode 13 and lower electrode 14 are formed. Moreover, the structure of this embodimetn shown in Fig. 7 can be obtained by depositing the anti-reflection film 15 forming SiN in the thickness equal to 1/4 of the wavelength of the signal beam at the end face in the side of optical modulator 11. In this embodiment, the length of resonator of DFB laser 10 is set to 300 $\mu$m, oscillation wavelength is set to 1.57 $\mu$m, length of optical modulator 11 is set to 200 um and PL peak wavelength of optical absorbing layer 6 is set to 1.40 $\mu$m.

In this embodiment, the junction area of DFB laser 10 and optical modulator 11 is formed as the tapered area but it is nevitably formed small in size during the liquid growth processing and therefore it does not give a large influence on matching of optical coupling.

In addition, such tapered area can be eliminated by the liquid growth of the optical absorbing layer 6 in the MOCV method.

In case the light absorbing layer 6 is formed by the multiple quantum well structure (MQW), the modulation characteristics of optical modulator 11 can further be improved.

[Embodiment 3]

Fig. 14 is a diagram for explaining the other embodment of the present invention.

In this embodiment, the photoamplifier 30 and PIN photodetector 31 are integrated on the same substrate.

The basic structure is the same as that explained in the embodiment 2. The optical absorbing layer 6 in the embodiment 2 becomes the I type optical absorbing layer 201 and the diffraction grating 200 having the $\lambda$/4 shift area is formed at the center under the optical absorbing layer 201.

The structure of this embodiment is manufactured by the same method as the embodiment 2.

In this embodiment, the optical waveguide layer 3 is formed by InGaAsP (wavelength $\lambda_{PL}$ = 1.1 $\mu$m) in the thickness of 0.1~0.2 $\mu$m; the etching stop layer 16, by InP in the thickness of 0.01 0.02 $\mu$m; the active layer 4 of photoamplifier, by InGaAsP (wavelength $\lambda_{PL}$ = 1.56 1.60 $\mu$m) in the

thickness of 0.1~0.2 $\mu$m; the I type optical absorbing layer 201, by I type InGaAs (wavelength $\lambda_{PL}$ = 1.67 $\mu$m), in the thickness of 0.1~ 0.2 $\mu$m; the clad layer 5, by p type InP in the thickness of 0.5 $\mu$m; and the cap layer 12, by InGaAsP (wavelength $\lambda_{PL}$ = 1.3 $\mu$m) in the thickness of 0.2 $\mu$m.

Moreover, length of the photoamplifier 30 is set to 100~600 $\mu$m, and length of PIN photodetector 31 to 100~300 $\mu$m. With such structure, an integrated optical semiconductor device operating in the bandwidth of 1.55 $\mu$m can be obtained.

In the structure of this embodiment, a positive voltage is applied in the side of photoamplifier 30, the substrate is earthed, the light beam input in the side of photoamplifier 30 is amplified, a negative voltage is applied in the side of PIN photodetector 31 and the light beam input from the photoamplifier 30 is converted to an electrical signal.

In this case, the $\lambda$/4 shift diffraction grating 200 is formed in the PIN photodetector 31 and only the light beam having the wavelength determined by the period is received and therefore the noise beam emitted from the photodetector 30 can be reduced.

[Embodiment 4]

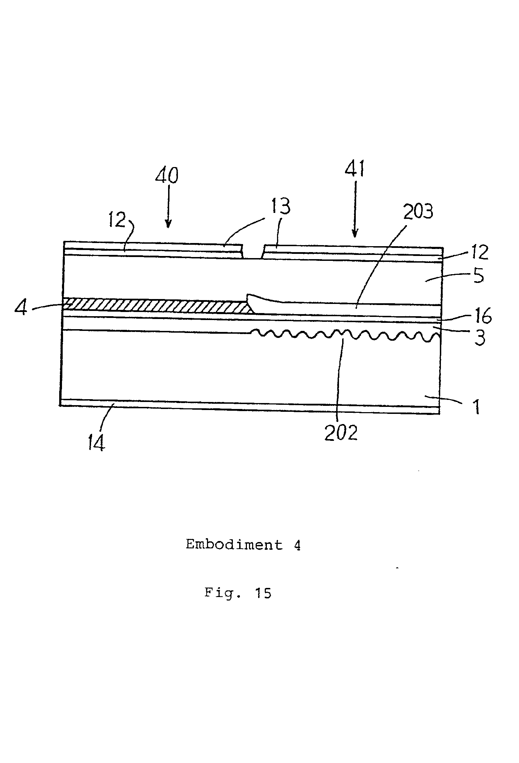

Moreover, Fig. 15 is a diagram for explaining the other embodiment of the present invention.

In this embodiment, a photodetector 40 and an optical filter 41 which is capable of changing the wavelength of transmitting light are integrated on the same substrate.

The basic structure is the same as that of the embodment 2. The optical absorbing layer 6 in the embodmient 2 becomes the filter active layer 203 and the diffraction grating 202 having the $\lambda$/4 shift area is formed at the center under such active layer.

The structure of this embodiment can be manufactured by the same method as that of embodiment 2.

In this embodiment, the optical waveguide layer 3 is formed by InGaAsP (wavelength $\lambda_{PL}$ = 1.1 $\mu$m) in the thickness of 0.1~0.2 $\mu$m; etching stop layer 16, by InP in the thickness of 0.01~ 0.02 $\mu$m; the active layer 4 of photodetector, by InGaAsP (wavelength $_{PL}$ = 1.56~1.60 $\mu$m) in the thickness of 0.1~0.2 $\mu$m; the filter active layer 203, by n type InGaAsP (wavelength $\lambda_{PL}$ = 1.3 $\mu$m) in the thickness of 0.1~0.2 $\mu$m; the clad layer 5, by p type InP in the thickness of 0.5 $\mu$m; the cap layer 12, by InGaAsP (wavelength $\lambda_{PL}$ = 1.3 $\mu$m) in the thickness of 0.2 $\mu$m.

The length of photodetector 40 is set to 100~600 $\mu$m and the length of optical filter 41 is set to 300~ 1000 $\mu$m. With the structure described above, an integrated optical semiconductor device operating in the bandwidth of 1.55 μm can be obtained.

In the structure of this embodiment, a positive voltage is applied in the side of photodetector 40, the substrate is earthed, the light beam applied in the side of photodetector 40 is amplified, the refractive index is changed by applying a positive voltage in the side of optical filter 41 to impress a current and the light transmitting wavelength determined by the structure of the λ/4 shift diffraction grating formed in the lower side is varied.

Moreover, since the λ/4 shift diffraction grating 200 in the optical filter 41 selects the light in the wavelength determined by the period, noise beam in the photoamplifier 30 is reduced.

Moreover, the filter active layer 203 is formed as the single layer in this embodiment and the filter characteristics can further be improved by employing the multiple quantum well structure (MQW). In case the filter active layer 203 employs the MQW structure, the refractive index is changed by applying a negative voltage to the optical filter.

In the embodiments described above, only two optical semiconductor devices are integrated. But the present invention is not limited only to such a structure and the present invention can naturally be apaplied to the structure integrating three or more optical semiconductor devices. In addition, the semiconductor material used and sizes thereof are not limited to those applied in above embodiments.

## Claims

1. (1) An integrated optical semiconductor device comprising:

    a semiconductor substrate providing an optical waveguide layer as the surface layer;

    a first optical semiconductor device providing a first active layer partially formed on said optical waveguide layer to operate through optical coupling between said optical waveguide layer and first active layer; and

    a second optical semiconductor device providing a second active layer which is in contact with the end face of the first active layer at the end face thereof for optical coupling and is formed on the same plane as said first active layer of said optical waveguide layer.

2. (2) An integrated optical semiconductor device according to claim (1), wherein said first and second active layers are substantially the same in the thickness.

3. (3) An integrated optical semiconductor device according to claim (1), wherein the diffraction grating is provided on the surface of said semiconductor substrate under said first active layer.

4. (4) An integrated optical semiconductor device according to claim (3), wherein said first active layer is a laser active layer for laser oscillation and said second active layer is an optical absorbing layer for controlling absorption and transmission of light with an input voltage.

5. (5) An integrated optical semiconductor device according to claim (4), wherein said absorbing layer consists of multiquantum well structure.

6. (6) An integrated optical semiconductor device according to claim (3), wherein said first active layer is an optical absorbing layer which detects the incident light and converts into an electrical signal, and said second active layer is an amplifier active layer for amplifying an incident light.

7. (7) An integrated optical semiconductor device according to claim (6), wherein said diffraction grating provides therein the λ/4 shift area.

8. (8) An integrated optical semiconductor device according to claim (3), wherein said first active layer is a filter active layer for changing the refractive index with an external input and said second active layer is an amplifier active layer for amplifying an incident light.

9. (9) An integrated optical semiconductor device according to claim (8), wherein said filter active layer has the multiple quantum well structure and changes the refractive index depending on an input voltage.

10. (10) An integrated optical semiconductor device according to claim (8), wherein said diffraction grating has therein the λ/4 shift area.

11. (11) A method of manufacturing an integrated optical semiconductor device comprising the steps of:

    forming an optical waveguide layer on a semiconductor substrate;

    forming an etching stop layer on said optical waveguide layer;

    forming a first active layer, on said etching stop layer, formed by a substance different from that of such etching stop layer;

    exposing said etching stop layer by selectively etching said first active layer; and

    forming a second active layer in contact with the surface exposed by the selective etching of said first active layer.

12. (12) An integrated optical semiconductor device according to claim (11), wherein said first and second active layers are substantially the same in the thickness.

13. (13) A method of manufacturing an integrated optical semiconductor device, further comprising a step of forming the diffraction grating to the area where said first active layer as the surface layer of said semiconductor substrate is selectively left by the selective etching.

14. (14) A method of manufacturing an integrated optical semiconductor device according to claim (13), wherein said diffraction grating provides the λ/4 shift area.

Prior Art

Fig. 1

Prior Art

Fig. 2

Prior Art

Fig. 3

Prior Art

Fig. 4

Embodiment 1

Fig. 5

Embodiment 1

Fig. 6

Embodiment 2

Fig. 7

Embodiment 2

Fig. 8

Sectional View

Fig. 9

Sectional View

Fig. 10

20

5

7

4

6

16

3

1

Sectional View

Fig. 11

12

5

7

4

6

16

3

1

Sectional View

Fig. 12

Sectional View

Fig. 13

Embodiment 3

Fig. 14

Embodiment 4

Fig. 15

# INTERNATIONAL SEARCH REPORT

International Application No PCT/JP90/00126

## I. CLASSIFICATION OF SUBJECT MATTER (if several classification symbols apply, indicate all) 6

According to International Patent Classification (IPC) or to both National Classification and IPC

Int. Cl$^5$        H01S3/18, H01L27/14

## II. FIELDS SEARCHED

Minimum Documentation Searched 7

| Classification System | Classification Symbols |
|---|---|
| IPC | H01S3/18, H01L27/14 |

Documentation Searched other than Minimum Documentation
to the Extent that such Documents are Included in the Fields Searched 8

Jitsuyo Shinan Koho                1966 - 1989
Kokai Jitsuyo Shinan Koho          1971 - 1989

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 64-28984 (NEC Corporation), 31 January 1989 (31. 01. 89), line 18, upper left column to line 9, upper right column, page 3; lines 7 to 10, upper left column to lines 19 to 20, upper left column, page 4 (Family: none) | 1 - 14 |
| Y | JP, A, 64-5088 (Toshiba Corp.), 10 January 1989 (10. 01. 89), lines 4 to 11, upper right column, page 3; lines 3 to 8, lower left column, page 4; lines 11 to 13, lower left column, page 5 (Family: none) | 1-5, 11-14 |
| Y | JP, A, 64-24483 (Kokusai Denshin Denwa Co., Ltd.), 26 January 1989 (26. 01. 89), Fig. 2 (Family: none) | 8, 10 |
| Y | JP, A, 58-44785 (Kokusai Denshin Denwa Co., Ltd.), 15 March 1983 (15. 03. 83), | 1-4, 11-14 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| April 23, 1990 (23. 04. 90) | May 7, 1990 (07. 05. 90) |
| International Searching Authority | Signature of Authorized Officer |
| Japanese Patent Office | |

Form PCT ISA 210 (second sheet) (January 1985)

FURTHER INFORMATION CONTINUED FROM THE SECOND SHEET

| | | |
|---|---|---|
| | line 8, upper right column to line 3, lower left column; page 2 (Family: none) | |
| Y | JP, A, 64-17487 (Matsushita Electric Ind. Co., Ltd.), 20 January 1989 (20. 01. 89), (Family: none) | 5 |
| Y | JP, A, 59-119783 (Nippon Telegraph & Telephone Corporation), 11 July 1984 (11. 07. 84), (Family: none) | 9, 10 |

V.☐ OBSERVATIONS WHERE CERTAIN CLAIMS WERE FOUND UNSEARCHABLE [1]

This international search report has not been established in respect of certain claims under Article 17(2) (a) for the following reasons:

1.☐ Claim numbers , because they relate to subject matter not required to be searched by this Authority, namely:

2.☐ Claim numbers , because they relate to parts of the international application that do not comply with the prescribed requirements to such an extent that no meaningful international search can be carried out, specifically:

3.☐ Claim numbers , because they are dependent claims and are not drafted in accordance with the second and third sentences of PCT Rule 6.4(a).

VI.☐ OBSERVATIONS WHERE UNITY OF INVENTION IS LACKING [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

| FURTHER INFORMATION CONTINUED FROM THE SECOND SHEET | | |
|---|---|---|
| Y | JP, A, 59-125660 (NEC Corporation), 20 July 1984 (20. 07. 84), (Family: none) | 6, 7 |
| Y | JP, A, 50-159287 (Tokyo Kogyo Daigaku-cho), 23 December 1975 (23: 12. 75), lines 6 to 12, lower right column, page 3 (Family: none) | 6 |

V.☐ OBSERVATIONS WHERE CERTAIN CLAIMS WERE FOUND UNSEARCHABLE ¹

This international search report has not been established in respect of certain claims under Article 17(2) (a) for the following reasons:

1.☐ Claim numbers      , because they relate to subject matter not required to be searched by this Authority, namely:

2.☐ Claim numbers      , because they relate to parts of the international application that do not comply with the prescribed requirements to such an extent that no meaningful international search can be carried out, specifically:

3.☐ Claim numbers      , because they are dependent claims and are not drafted in accordance with the second and third sentences of PCT Rule 6.4(a).

VI.☐ OBSERVATIONS WHERE UNITY OF INVENTION IS LACKING ²

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)